# DEMANDE DE BREVET EUROPEEN

(11) **EP 2 731 268 A1**
(43) Date de publication de la demande: **14.05.2014**
(21) Numéro de dépôt: 13191805.4
(22) Date de dépôt: 06.11.2013
(51) Int. Cl.: H03K 17/12

(54) **Dispositif d'amplification linéaire de puissance**

(30) Priorité: 09.11.2012 FR 1203014
(71) Demandeur: Thales, 92200 Neuilly Sur Seine (FR)
(72) Inventeur: Rambert, Bernard, 94150 RUNGIS (FR); Sintes, Christian, 94150 RUNGIS (FR); Lobit, Stéphane, 94150 RUNGIS (FR)
(74) Mandataire: Priori, Enrico

(57) **Abrégé**

La présente invention concerne un dispositif de fiabilisation pour amplificateur linéaire de puissance, le dispositif comprenant un module d'alimentation (10), un module de régulation de courant (20) et un module de commutation (30), le module de régulation de courant (20) comportant une pluralité de branches de régulation (25) comprenant un régulateur à semi conducteur (21) et un capteur de courant (23, 201), le module de commutation (30) comprenant un commutateur semi conducteur (31), chaque régulateur à semi conducteur (21) étant commandé par une boucle d'asservissement (200) en fonction de la valeur du courant en sortie du dispositif d'amplification et de celui circulant dans la branches de régulation (25) comprenant ledit régulateur à semi conducteur (21).

## Description

La présente invention concerne le domaine de l'électronique de puissance La présente invention concerne notamment un dispositif d'amplification linéaire de puissance.

Dans le domaine de l'électronique de puissance, on constate que les dispositifs électroniques dont les composants de puissance sont soumis à des sollicitations thermiques de grande amplitude ont une durée de vie souvent bien inférieure à celle trouvée par le calcul standard du temps moyen entre panne (ou MTBF pour Mean Time Between Failures selon le sigle anglo-saxon).

Par exemple, dans le domaine du radar, les alimentations pour tube amplificateur utilisé en mode pulsé, font généralement appel à un modulateur utilisant une technologie à base de PFN. Les PFNs, acronyme Anglais pour Pulse Forming Network, sont des réseaux formeur d'impulsion utilisant un assemblage particulier de condensateurs et de selfs permettant de générer des impulsions électriques rectangulaires de très grande puissance.

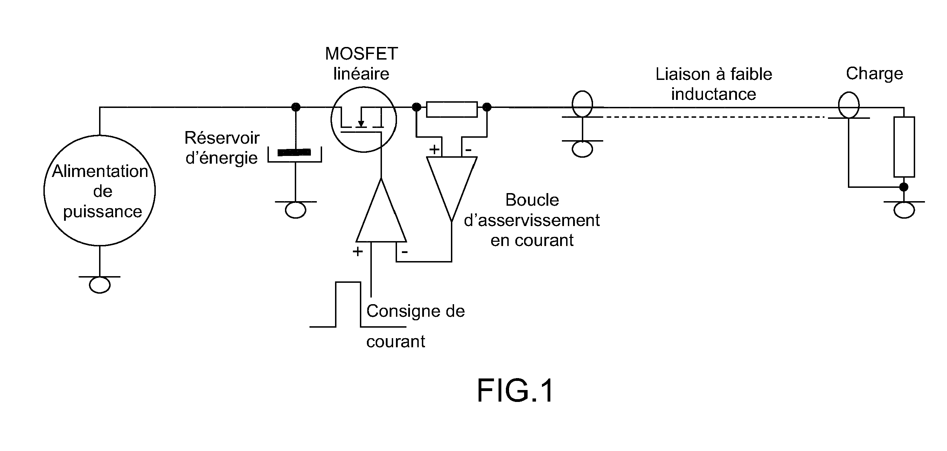

Les contraintes de compacité et d'agilité des matériels radars plus récents joints aux mutations technologiques ont réduit la part des réseaux PFN dans les radars modernes au profit de solutions " tout silicium ". A titre d'exemple, la figure 1 représente un mode de réalisation d'un modulateur de ce type. Dans ce mode de réalisation particulier, le composant de puissance est un transistor MOSFET fonctionnant en générateur de courant grâce à une boucle d'asservissement. L'association en parallèle de dizaines ou de centaines de transistors selon ce mode d'asservissement permet d'adapter la structure à la puissance demandée. Typiquement, cette puissance est de l'ordre de quelques kilowatts à quelques Mégawatts. Cette solution technique permet ainsi d'obtenir des impulsions rectangulaires calibrées électroniquement en durée et en amplitude.

Un problème de fiabilité des composants semi conducteur est apparu à la suite de l'exploitation d'un certain nombre de radars de grande puissance utilisant des modulateurs sans PFN. En effet, les modulateurs construits sur le modèle " tout silicium " ont révélé, une limitation sévère de la fiabilité, inexplicable par l'application des lois classiques de calcul du temps moyen entre panne ou MTBF. On constate au début de la phase d'exploitation des transistors qu'il existe une période limitée dans le temps où le flux de pannes est régi par les lois classiques du MTBF. Cette période est ensuite suivie par une forte augmentation du flux de pannes, comme si le matériel électronique avait atteint prématurément sa fin de vie ou que quelque chose avait précipité cette fin de vie.

Avec la maturation des transistors bipolaires à grille isolée (ou IGBT pour Insulated Gate Bipolar Transistor) pour la très forte puissance, des problèmes de fiabilités similaires sont apparus. Les fabricants d'IGBT ont identifié un phénomène de délaminage engendré par la répétition de contraintes différentielles entre matériaux possédant des coefficients de dilatation différents.

Un but de l'invention est notamment de corriger les inconvénients précités en proposant un dispositif d'amplification permettant d'augmenter et de mieux maitriser la durée de vie et donc la fiabilité des matériels.

A cet effet, l'invention a pour objet un dispositif d'amplification linéaire de puissance comprenant, un module d'alimentation, un module de régulation de courant et un module de commutation,
- Le module de régulation de courant comportant une pluralité de branches de régulation connectées en parallèle entre elles, la pluralité de branches de régulation étant connectée en série entre le module d'alimentation et le module de commutation, chacune desdites branches de régulation comprenant un régulateur à semi conducteur, fonctionnant en mode linéaire, connecté en série avec un capteur de courant,
- Le module de commutation comprenant un commutateur semi conducteur,
- Chaque régulateur à semi conducteur étant commandé par une boucle d'asservissement en fonction de la valeur du courant en sortie du dispositif d'amplification et de celui circulant dans la branche de régulation comprenant ledit régulateur à semi conducteur.

Selon une variante de réalisation, le module d'alimentation comporte une alimentation haute tension connecté en série avec une alimentation auxiliaire afin d'accélérer la vitesse de montée en courant.

Selon une variante de réalisation, le module de commutation comporte un circuit d'aide à la commutation comprenant une alimentation, un condensateur et une diode.

Selon une variante de réalisation, chaque branche de régulation comprend un fusible.

Selon une variante de réalisation, un même fusible protège plusieurs branches de régulation.

L'invention a notamment pour principaux avantages de permettre une maîtrise de l'amplitude des cycles thermiques du dispositif d'amplification et, en agissant sur l'architecture électronique du dispositif d'amplification, de permettre de fiabiliser le matériel incorporant ce dispositif d'amplification en le rendant plus tolérant aux pannes.

De façon avantageuse, le cumul de ces deux caractéristiques permet d'une part d'effectuer une meilleur prédiction de la durée de vie du matériel, mais aussi de fiabiliser cette prédiction. En effet, la tolérance de panne permet d'éviter l'arrêt dès la première panne. Cela évite les surprises désagréables des pannes aléatoires, toujours possibles.

La présente invention peut trouver une application dans les dispositifs nécessitants de faire fonctionner des composants de puissance dans des conditions de forte charge thermique. Ces conditions peuvent se rencontrer lorsque coexistent une tension de déchet importante et un courant non négligeable. L'application est particulièrement intéressante notamment lorsque cette puissance est pulsée et en présence de variations importantes, rapides et fréquentes du facteur de charge comme par exemple en présence de charges électroniques actives, d'amplificateurs en mode linéaire, dans le cas de modulateurs pour émetteur radar etc...

La compréhension de ces phénomènes et leur traitement peut intéresser toute application électronique employant des puces de taille importante et susceptibles de cycles thermiques de grande amplitude. Cela concerne aussi bien les calculateurs (très sensibles par exemple aux cyclages marche/arrêt) que les convertisseurs de puissance soumis à des alternances de charge très importantes suivies par des périodes de repos quasi total et ce à un rythme soutenu Ce cas de figure peut se rencontrer dans le domaine de la propulsion électrique en ville ou des assistances électroniques se caractérisant par une alternance de périodes de charge intense suivi de période de repos quasi complet, et ce à un rythme soutenu.

D'autres particularités et avantages de la présente invention apparaîtront plus clairement à la lecture de la description ci-après, donnée à titre illustratif et non limitatif, et faite en référence aux dessins annexés, dans lesquels :
- La figure 1 représente un exemple de mode de réalisation d'une branche d'amplification d'un modulateur radar ;
- La figure 2 représente un exemple de mode de réalisation d'un dispositif d'amplification selon l'invention ;
- La figure 3 est une représentation graphique suivant une échelle logarithmique en abscisse et ordonnée donnant l'espérance de vie, en nombre de cycles, de la brasure de report d'une puce silicium sur une pièce de cuivre ;
- La figure 4 est une représentation graphique donnant les mêmes informations que la figure 3 suivant une échelle linéaire en abscisse et logarithmique en ordonnée plus facile d'emploi.

La présente invention concerne les dispositifs nécessitant de faire fonctionner des composants de puissance dans des conditions de forte charge thermique c'est-à-dire en présence d'une tension de déchet et de courant importants. Par la suite, cette invention va être décrite à travers une application particulière dans le domaine des radars. Bien entendu, cet exemple n'est nullement limitatif et l'invention décrite peut trouver une application dans tout autre domaine où des composants de puissance fonctionnent dans des conditions de forte charge thermique.

A titre d'illustration, la figure 1 représente un exemple de mode de réalisation d'une branche d'amplification d'un modulateur de radar connu de l'art antérieur. Afin d'obtenir la puissance désirée, une multitude de telles branches d'amplifications sont mises en parallèle pour former un modulateur. Dans ce mode de réalisation, le composant de puissance, à savoir un transistor MOSFET 3 effectue à la fois les opérations de commutation et les opérations de régulation de courant. Au moment de la commutation, la tension aux bornes des transistors est de l'ordre de 800V et reste comprise entre environ 40V et 100V pendant la phase de régulation en courant.

Plusieurs transistors étant associés en parallèle, en cas de défaillance de l'un d'eux, tous les transistors commutent ensemble à l'exception du transistor défaillant qui absorbe alors tout le courant. Cependant, il faudra un certain temps au fusible de protection (non représenté) pour s'ouvrir. Ce temps est bien supérieur au temps de saturation du transformateur (non représenté) auquel est raccordé le modulateur. Il s'ensuit alors un courant de défaut pouvant dépasser les 10 000 Ampères. Le fusible doit donc s'ouvrir dans des conditions extrêmement éprouvantes de courant et de tension. Du fait de l'encombrement de ce type de fusible, il n'est pas toujours possible de protéger tous les transistors individuellement. Il suffit alors de la défaillance d'un seul transistor (avec destruction de la puce et de son support) pour arrêter tout le modulateur. Cette architecture ne tolère donc aucune panne de MOSFET, sauf à accepter de mettre un gros fusible de protection en regard de chaque transistor.

Par ailleurs, la montée en courant est relativement lente du fait de l'inductance parasite du transformateur de charge et du câblage avec pour conséquence la réduction de la période de travail utile du tube du radar et donc de son taux de travail effectif. Ce phénomène ne se rencontrait pas auparavant avec l'utilisation de modulateurs à base de PFN. En effet, du fait de l'impédance propre des PFN, la tension de charge devait être le double de la tension de travail. Il s'ensuivait que la vitesse de montée en courant et en tension était considérablement augmentée. De ce fait, la tension développée par le PFN au démarrage de l'impulsion restait supérieure à sa tension de travail tant que le courant n'avait pas atteint sa valeur nominale.

Avec un modulateur à MOSFET, pour obtenir une vitesse de montée en courant similaire, il faudrait augmenter significativement la tension de travail des transistors ce qui n'est pas compatibles les objectifs thermiques et de MTBF. Cette limitation peut induire une augmentation significative du facteur de travail du tube pouvant devenir incompatible de son aire de sécurité.

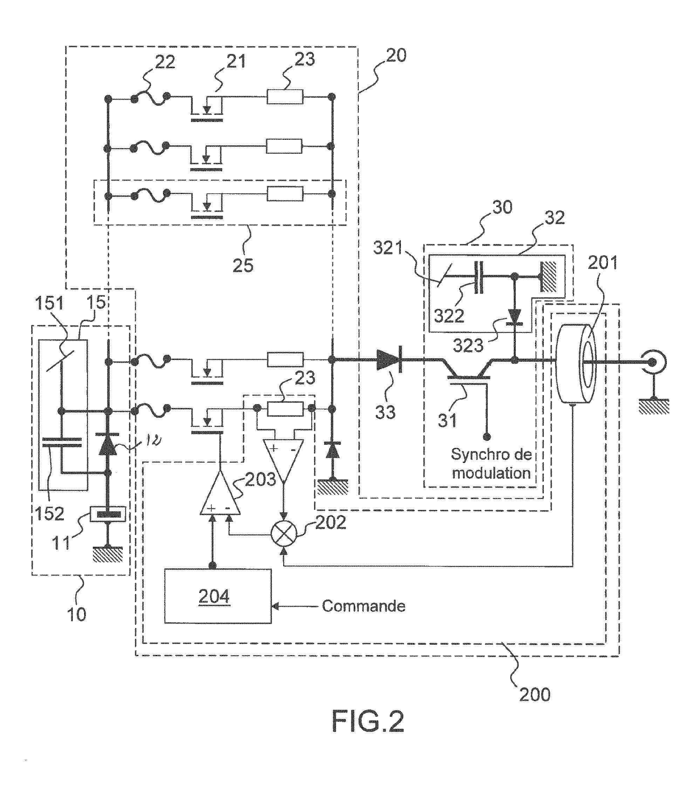

La figure 2 représente un exemple de mode de réalisation d'un dispositif d'amplification linéaire de puissance à tolérance de panne et durée de vie contrôlée selon l'invention. Dans ce montage, contrairement à celui de la figure précédente, la fonction de commutation est séparée de la fonction régulation de courant et ces deux fonctions sont assurées par des composants à semiconducteur de nature différente. Dans ce mode de réalisation, les composants assurant la régulation du courant c'est-à-dire les régulateurs à semi conducteur 21 sont mis en série avec un commutateur à semiconducteur 31.

De façon avantageuse, la séparation des fonctions de régulation de courant et de commutation permet de réduire les pertes ainsi que le stress électrique dans les composants linéaires et par voie de conséquence, de réduire l'amplitude des fluctuations de température dans ces mêmes composants. Ceci permet une augmentation importante de la durée de vie des composants de régulation et donc du matériel dans lequel est implanté le ou les dispositifs d'amplification.

Le dispositif d'amplification selon l'invention peut comprendre un module d'alimentation 10, un module de régulation de courant 20 et un module de commutation 30.

Le module d'alimentation 10 peut être formé d'une alimentation haute tension 11. Selon un mode de réalisation particulier nullement limitatif, l'alimentation 11 est une alimentation courant continu d'environ 750V de puissance environ égale à 10kW et de capacité environ 8 800 µF.

Par exemple, dans le cas d'une application pour un radar pulsé, le module d'alimentation10 peut comporter une alimentation auxiliaire 15 ou tension de kick-up selon le terme anglo saxon de façon à diminuer le temps de monté des impulsions. Cette tension auxiliaire 15 a pour but d'accélérer la vitesse de montée en courant des impulsions. Cette tension disparaît ensuite pour ne pas pénaliser la dissipation thermique dans les régulateurs 21 pendant la phase de plateau où le courant est stabilisé. Cette alimentation auxiliaire 15 peut comprendre une alimentation continue 151, une capacité 152 et une diode en parallèle dite " diode de by-pass " 12. Cette dernière est destinée à prendre le relais pendant la phase plateau, une fois la capacité 152 déchargée.

Le module de régulation de courant 20 est formé par la mise en parallèle de plusieurs branche de régulation 25 comprenant chacune au moins un régulateur à semiconducteur 21. Suivant un mode de réalisation, le régulateur de courant est un transistor MOS. Dans l'exemple particulier illustré figure 2, le régulateur de courant est un transistor MOSFET.

De façon avantageuse, l'augmentation du nombre de régulateurs à semiconducteur permet de répartir la puissance thermique sur un grand nombre de composants et donc de diminuer la puissance moyenne dissipée par chaque régulateur 21.

Un autre avantage de ce mode de réalisation vient du fait que la régulation de courant en mode linéaire est assurée par des composants dédiés n'assurant plus la fonction de commutation. Ceci permet maintenir en place un ou plusieurs composants défaillants. Dans ce cas, le composant défaillant joue le même rôle qu'un composant passif. Le système d'asservissement en courant global devra tenir compte de ce changement pour maintenir l'objectif de régulation souhaité. Ainsi, le travail de commutation que devra effectuer le composant 31 ne s'en trouvera pas altéré. Cet aménagement permet de s'accommoder d'une telle défaillance. Il s'agit de la fonction "tolérance de panne". Dans le cas où la défaillance entraînerait un état de court circuit franc, une protection par fusible 22 individuel peut être prévue. Dans ce cas, le fusible 22 viendrait isoler le composant défaillant dans des conditions extrêmement douces, évitant toute surtension puisque sans travail de commutation. Le temps de fusion et l'énergie de coupure ne présentent plus qu'une criticité réduite dans choix du type de fusible. Ceci permet d'implémenter des fusibles 22 plus simples et de plus petite taille au niveau des régulateurs semiconducteur 21. Compte tenu du fait que le travail d'ouverture du circuit est toujours rempli par le commutateur de puissance, le fusible 22 de protection peut être un fusible basse tension.

Suivant un autre mode de réalisation, un même fusible 22 peut protéger plusieurs régulateurs de courant 21. Dans ce cas, un même fusible 22 peut être mis en série avec plusieurs branches de régulation 25 mises en parallèle afin de protéger les régulateurs de courant 21.

Chaque branche de régulation 25 comporte au moins un capteur de courant 23, 201, comme par exemple une résistance shunt ou un tore d'intensité, associé à une boucle d'asservissement 200. Pour des raisons de clarté, afin de ne pas surcharger la figure, seule une boucle d'asservissement 200 a été représentée. Cette boucle 200 a pour fonction de permettre au dispositif d'amplification de pouvoir fonctionner de façon fiable pour un nombre variable de régulateur de courant 21 en panne et pour une configuration de défaillance inconnue c'est-à-dire avec un nombre de fusible 22 coupé inconnu. Pour ce faire, la boucle d'asservissement 200 utilise le signal représentatif de la valeur du courant total Iₜₒₜ fourni par le système et le signal représentatif de la valeur du courant I_{B} circulant dans la branche de régulation 25 considérée. Le signal représentatif de la valeur du courant total est mêlé au signal représentatif de la valeur du courant mesurée sur la branche de régulation 25, par exemple par l'intermédiaire d'un sommateur 202, pour générer un signal représentatif de l'information mixte de courant Iₘᵢₓ. Ce signal est comparé, par exemple à l'aide d'un comparateur 203, à un signal représentatif d'une valeur de référence I_{ref} délivrée par exemple par un module de consigne 204. Suivant un mode de réalisation, ce module de consigne 204 peut être une commande digitale de courant commandée par un signal numérique de consigne.

La figure 2 présente deux solutions différentes de prise en compte de l'information de courant, l'une par une résistance shunt 23 et l'autre par tore d'intensité 201. Ces exemples ne sont nullement limitatifs et tout capteur de courant peut être utilisé pour chaque fonction.

De façon avantageuse, le tore d'intensité donne une plus grande dynamique en tension pour une puissance dissipée plus faible. Cette caractéristique de grande dynamique en tension peut être utilisée pour générer des signaux représentatifs du courant mesuré de grande amplitude permettant de limiter le gain de la boucle d'asservissement 200. De ce fait il n'est plus nécessaire de donner du gain à la boucle d'asservissement 200, auquel cas, le recours à des circuits actifs devient non nécessaire. On obtient alors une boucle de régulation particulièrement rapide, puissante et stable suivant le choix qui aura été fait des tores d'intensité. L'utilisation du tore d'intensité peut être généralisée à la totalité des capteurs de courant suivant le choix du concepteur.

Suivant un mode de réalisation le taux de mixité (ou compoundage suivant le terme anglo-saxon) entre le signal représentatif du courant total et le signal représentatif du courant circulant dans la branche de régulation considéré peut être réglable. Ceci permet d'ajuster le mélange de ces informations de courant suivant les caractéristiques de régulation que l'on souhaite obtenir.

A titre d'exemple, si l'on considère qu'un préréglage usine permet de pré-positionner chaque branche de régulation 25 à une valeur de courant proche de son état de fonctionnement permanent, on pourra privilégier l'information du courant de sortie et donner une pondération plus importante au signal représentatif de ce courant par rapport au signal représentatif du courant circulant dans la branche de régulation considérée. Le mélangeur 202 pourra par exemple être réglé de façon à ce que 80% de l'information de courant provienne du signal représentatif du courant de sortie. En cas de panne de l'un des régulateurs 21 à semiconducteur, on observera une légère dérive du courant de sortie. Cette dérive pourra être corrigée par une opération de réglage manuel par exemple à l'occasion d'une maintenance périodique ou provoquée pour ramener la valeur de courant à sa valeur idéale. Ainsi, au fil des défaillances de régulateur de courant 21 et des reprises de réglage périodiques, le dispositif d'amplification pourra être maintenu à poste pendant un temps très long avant que le seuil de tolérance maximum admissible par les régulateurs de courant 21 ne soit atteint.

Le module de régulation 20 est connecté en série avec un module de commutation 30. Ce module 30 comporte principalement un commutateur à semiconducteur 31. La commutation est réalisée par un commutateur à semiconducteur 31 unique pour plusieurs branches de régulation 25 en parallèle. Le commutateur à semiconducteur 31 se retrouvent ainsi en série sur une branche de courant fort et doit assurer la fonction de commutation pour cette branche de courant.

Suivant un exemple de réalisation, ce commutateur 31 est un transistor bipolaire à grille isolée ou IGBT pour Insulated Gate Bipolar Transistor selon la terminologie anglo saxone. De façon avantageuse les IGBT de puissance sont capables de supporter de grosses surcharges de courant et de tension, et présentent l'avantage d'être spécialisés pour la commutation avec de faibles pertes de commutation et de faibles pertes à l'état passant.

Les composants de commutation peuvent être choisis pour leur qualité de construction. Le choix peut par exemple se faire en sélectionnant des matériaux présentant des coefficients de dilatation linéaires aussi proche que possible les uns des autres. Par exemple, un alliage aluminium-carbure de silicium (ou AlSiC) peut être choisi pour la pièce de report de la puce et le nitrure d'aluminium (ou AIN) pour l'isolation galvanique. D'autre part, ce composant peut être largement dimensionné pour ne plus présenter de problème de fiabilité.

Une diode anti retour 33 peut être connectée en série avec le commutateur 31 et le module de régulation 20. Le module de commutation peut comporter un réseau d'aide à la commutation 32. Ce réseau peut être formé d'une alimentation 321, d'une capacité 322 et d'une diode 323. Ce réseau 32 à pour fonction d'allonger légèrement le temps de coupure du commutateur à semiconducteur 31 afin d'éviter que cette coupure ne soit trop brutale. Cet allongement du temps de coupure permet de réduire la surtension générée aux bornes du commutateur 31. Une fois ce commutateur ouvert, le courant va continuer de circuler dans le réseau d'aide à la commutation 32 qui va résister de plus en plus au passage du courant continu de part la présence du condensateur 322 de très petite valeur.

Le ralentissement de la commutation par un circuit extérieur permet également d'éviter de faire chauffer le commutateur semiconducteur 32 sachant que l'échauffement peut avoir un impact sur sa durée de vie et que ce composant est critique.

Le fonctionnement de la tolérance de panne va à présent être expliqué.

Lorsque le commutateur à semiconducteur 31 devient passant (commutation en position ON), la valeur du courant augmente jusqu'à atteindre la valeur de régulation prescrite (ou consigne) et se stabiliser à cette valeur.

Pour info, la valeur de la tension de l'alimentation continue 11 est réglée à la valeur minimum pour permettre un fonctionnement précis des régulateurs de courant 21 travaillant en mode linéaire. De façon avantageuse, ce réglage permet de minimiser la puissance thermique à évacuer par puce.

Lorsque la valeur de la consigne de courant est variable, le dispositif de régulation doit être capable de moduler l'amplitude du courant de sortie suivant cette consigne variable. Pour ce faire, la valeur de la tension d'alimentation continue, ainsi que la valeur de la tension de déchet des régulateurs de courant 21, sont réglées de façon à permettre au dispositif d'amplification d'atteindre les valeurs maximales du courant de sortie que peut exiger la valeur de consigne.

Lorsque le commutateur à semiconducteur 31 est bloqué (commutation en position OFF), le courant est interrompu. La valeur du courant circulant dans les branches de régulation 25 tombe à zéro et tous les régulateurs de courant 21 se retrouvent conducteur avec une tension de déchet nulle à leurs bornes. Les régulateurs de courant 21 n'assurant plus la fonction de commutation, ils ne sont plus soumis au stress de commutation de plus, la tension à l'état bloqué est nulle.

En cas de défaillance d'un des régulateurs de courant 21, le courant de sortie (commutateur 31 à l'état ON) reste à la même valeur du fait de la présence des boucles de régulation 25. Il s'ensuit que la valeur de la tension de sortie du dispositif d'amplification reste inchangée et que la valeur de la tension de déchet aux bornes des régulateurs de courant 21 reste inchangée elle aussi. Ainsi, le régulateur de courant 21 défaillant ne voit pas d'évolution de la tension à ses bornes. Le courant traversant le régulateur de courant 21 défaillant dépend de l'impédance qu'il continue de présenter (typiquement plusieurs Ohms). Si la valeur de ce courant est inférieure à la valeur permise par le fusible 22, ce dernier ne fond pas et le composant défaillant reste en ligne pour une durée indéfinie. La boucle de régulation 200 permet d'agir sur les régulateurs de courant 21 encore actifs de façon à maintenir le courant de sortie à la valeur souhaitée. Cette configuration permet de ne pas reporter la totalité du courant de la branche défaillante sur les autres branches, ce qui soulage d'autant les autres régulateurs de courant 21 et augmente la tolérance aux pannes du système.

Si la valeur de l'impédance du régulateur de courant 21 défaillant devient trop faible, le fusible 22 fond coupant ainsi le courant dans la branche de régulation 25. Les conditions de fusion et d'ouverture du fusible correspondent à une tension inférieure ou égale à la tension de déchet des autres régulateurs de courant 21 ou une tension nulle pendant les phases où le commutateur à semiconducteur 31 interrompt le courant de sortie du dispositif d'amplification. Il n'y a donc pratiquement aucun travail de coupure du courant puisque ce travail est effectué par le commutateur de puissance à semiconducteur 31. Par rapport au montage illustré figure 1, il est donc possible d'installer des fusibles 21 moins puissants aux dimensions plus modestes pouvant par exemple loger sur une carte de circuit imprimé. La seule condition à respecter est que ce fusible soit capable de supporter la tension d'alimentation après claquage (à courant nul). Cette situation peut se rencontrer en cas de court circuit de la charge. La valeur de la tension de déchet des régulateurs de courant 21 atteint rapidement la valeur de la tension d'alimentation jusqu'à ce que les circuits de protection remette le commutateur à semiconducteur 31 à l'état bloqué (état OFF).

De façon avantageuse, cette nouvelle architecture de dispositif d'amplification permet d'améliorer la maitrise et la détermination de la durée de vie des régulateurs à semiconducteur.

Les variations de température des puces induisent des variations de température dans tout l'empilement des structures de report de ladite puce sur la plaque froide. Etant donnée que les coefficients de dilatation linéaire de tous ces éléments ainsi que du matériau utilisé pour les brasures sont différents les uns des autres, il s'ensuit des contraintes de dilatation différentielles plus ou moins importantes pouvant induire des contraintes mécaniques plus ou moins importantes entre chacun d'eux. Un dommage apparaît généralement au niveau de cette brasure, qui est proportionnel à l'amplitude de l'écart de dilatation différentiel et au nombre de cycles thermiques. La brasure assurant l'assemblage entre la puce et sa semelle de report en cuivre est donc particulièrement exposée à ce type de contrainte.

Ce problème peut être rapproché de celui du vieillissement d'une pièce mécanique qui serait soumis à des contraintes mécaniques alternées. Dans ce cas, la durée de vie de la pièce n'est pas évaluée suivant sa probabilité de défaillance mais plutôt suivant son nombre de cycles en utilisant la notion de dommage pour quantifier la part de durée de vie consommée par les contraintes mécaniques sur une période donnée.

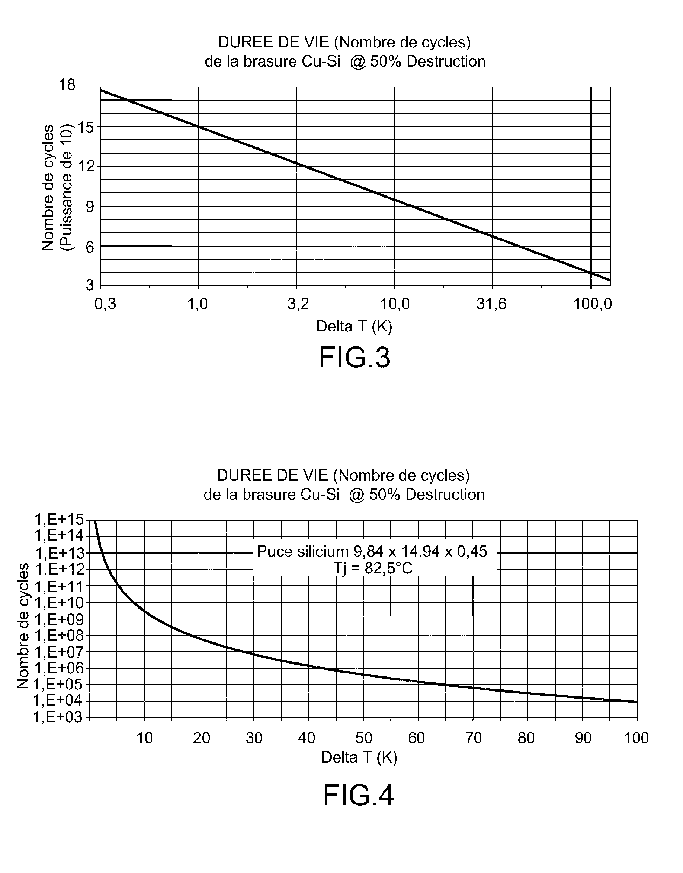

Sur cette même idée, des abaques ont été créés pour prédire la durée de vie des composants selon l'amplitude et la fréquence des cycles thermiques. A titre d'illustration, la figure 3 présente un exemple d'une telle abaque en échelle log/log. L'intérêt de l'échelle log/log dans ce cas précis est qu'elle fait apparaître une droite. L'existence d'une telle droite est la preuve qu'il existe une loi mathématique sous jacente liant espérance de vie et amplitude thermique, et que cette loi est valable sur une échelle d'espérance de vie de plus de 10 ordres de grandeurs.

La figure 4 illustre le nombre moyen de cycles thermiques qu'est capable d'endurer une puce silicium de taille 9,84 x 14,94 x 0,45 µm³ et de température moyenne estimée entre 80°C et 85°C jusqu'à la rupture. Dans cette représentation lin/log, la loi mathématique sous jacente est moins évidente que dans le cas de la représentation figure 3, mais elle est plus facile à appréhender pour les concepteurs de circuits électroniques. C'est sous cette forme ou sous une forme voisine qu'elle est le plus souvent communiquée par les fabricants de puces électroniques aux électroniciens concepteurs.

Pour ces deux cas de figure, il s'agit de données statistiques recueillies dans le cadre d'une application particulière, et le nombre de cycles thermiques représente la valeur à partir de laquelle on peut estimer qu'il y a un risque sérieux de destruction de la puce dans ce type d'application. Les valeurs recueillies sont cependant suffisamment proches de celles obtenues auprès des fabriquants de puce pour qu'on puisse s'y référer.

L'emploi de puces plus petites pour une même température de jonction induit des contraintes de dilatation différentielles plus petites. Ainsi, on peut estimer qu'une division par 2 de la surface de silicium donnerait un dommage environ 6,8 fois plus faible pour une amplitude identique de cycle thermique. La taille de puce indiquée plus haut est relativement standard et correspond à une puissance de puce "moyenne". Au-delà de ces dimensions, l'augmentation de puissance peut être obtenue par la mise en parallèle de puces semblables. C'est ainsi que l'on peut rencontrer des composants de très forte puissance intégrant plusieurs dizaines de puces sous un même boîtier. Dans ces conditions, la durée de vie n'est alors pas considérablement affectée par le nombre de puces en parallèle dans ce type de composant puisque toutes atteindront leur limite de durée de vie au même moment.

Il est à noter que les matériels ne sont généralement pas confrontés qu'à un seul type de cycle thermique mais plutôt à tout un spectre de cycles thermiques comme par exemple des alternances marche/arrêt, des cycles jour/nuit, des alternances climatiques. Dans le cas du radar on peut également citer les différents thèmes d'emploi ou le profil d'exploitation. Chacun de ces cycles induit un dommage correspondant à son spectre d'amplitude et de fréquence. L'utilisation de la courbe illustrée figure 4 permet de déterminer la quantité de dommage infligée par chacune des composantes du spectre de cycles thermiques et d'en déterminer le dommage résultant subit en une année par chacun des composants. On en déduit alors leur durée de vie dans un matériel donné suivant un thème d'emploi donné.

Par ailleurs, on remarque que chaque cycle thermique d'amplitude 5°C inflige 10 000 fois plus de dommage qu'un cycle thermique de 1°C d'amplitude. Ainsi ce ne sont pas nécessairement les sauts de température les plus répétés qui sont les plus pénalisants. Par exemple, dans le cas d'un modulateur pour une application radar, les formes d'ondes avec des variations importantes et fréquentes du facteur de charge sont potentiellement plus dévastatrices pour les puces que les formes d'onde récurrentes à facteur de charge maximum.

Tous ces dommages s'additionnent, et si chaque raie ne représente individuellement qu'un très faible dommage annuel, le cumul de toutes ces raies peut donner un dommage résultant beaucoup plus important, de nature à limiter très sévèrement l'espérance de vie du produit. Ainsi, les tests cycliques à températures extrêmes, comme par exemple entre environ -40°C et environ +150°C, ne donneraient qu'une espérance de vie estimée de 2000 cycles environ (T moyen = +55°C) et moins de 100 cycles pour les tests [-50/+200°C]. On peut donc considérer qu'un test de cyclage thermique mal compris peut entamer sérieusement l'espérance de vie d'un composant. En particulier, on quitte la zone des pannes de MTBF pour entrer dans la zone des pannes de fin de vie. Ceci illustre l'une des raisons limitant la taille des puces produites par les producteurs de composants silicium, et montre aussi pourquoi on se heurte à un problème de nombre de cycles dès lors que l'on cherche à éprouver le MTBF de composants silicium par des cycles thermiques de grande amplitude.

La séparation des fonctions de commutation et de régulation peut permettre une réduction de l'ordre de 25% à 30% de la puissance à dissiper dans les régulateurs. Cette réduction de puissance à deux principaux avantages.

Grace à l'abaissement de la température moyenne, cette séparation permet une augmentation supplémentaire de la durée de vie des régulateurs à semiconducteur. A titre d'exemple, une diminution de la température moyenne de la puce de 15°C permet d'augmenter la durée de vie de la puce d'environ un facteur 1,5.

La diminution de l'amplitude des cycles thermiques permet également une augmentation de la durée de vie du régulateur. A titre d'exemple, une diminution de 15°C de l'amplitude des cycles thermique peut multiplier la durée de vie du régulateur d'un facteur cinq.

Ainsi, ce simple changement de topologie peut donc augmenter d'un facteur 7,5 la durée de vie des régulateurs à semiconducteur, et il permet également d'obtenir une disponibilité proche de 100% durant toute la durée de vie du matériel grâce à la fonction de tolérance de pannes.

De façon avantageuse, l'architecture particulière du dispositif d'amplification selon l'invention permet de réduire le taux de pannes des composants linéaires particulièrement exposés au risque de défaillance et permet à l'ensemble du dispositif de continuer sa fonction malgré la défaillance d'un ou plusieurs de ces composants.

## Revendications

1. Dispositif d'amplification linéaire de puissance **caractérisé en ce qu'il** comprend, un module d'alimentation (10), un module de régulation de courant (20) et un module de commutation (30),
- Le module de régulation de courant (20) comportant une pluralité de branches de régulation (25) connectées en parallèle entre elles, la pluralité de branches de régulation (25) étant connectée en série entre le module d'alimentation (10) et le module de commutation (30), chacune desdites branches de régulation (25) comprenant un régulateur à semi conducteur (21), fonctionnant en mode linéaire, connecté en série avec un capteur de courant (23, 201),
- Le module de commutation (30) comprenant un commutateur semi conducteur (31),
- Chaque régulateur à semi conducteur (21) étant commandé par une boucle d'asservissement (200) en fonction de la valeur du courant en sortie du dispositif d'amplification et de celui circulant dans la branche de régulation (25) comprenant ledit régulateur à semi conducteur (21).

2. Dispositif selon la revendication précédente **caractérisé en ce que** le module d'alimentation (10) comporte une alimentation haute tension (11) connecté en série avec une alimentation auxiliaire (15) afin d'accélérer la vitesse de montée en courant.

3. Dispositif selon une des revendications précédentes **caractérisé en ce que** le module de commutation (30) comporte un circuit d'aide à la commutation (32) comprenant une alimentation, un condensateur et une diode.

4. Dispositif selon une des revendications précédentes **caractérisé en ce que** chaque branche de régulation (25) comprend un fusible (22).

5. Dispositif selon une des revendications 1 à 4 **caractérisé en ce qu'**un même fusible (22) protège plusieurs branches de régulation (25).
